# EUROPÄISCHE PATENTSCHRIFT

(11) **EP 0 542 943 B1**
(45) Veröffentlichungstag und Bekanntmachung des Hinweises auf die Patenterteilung: **19.08.1998**
(21) Anmeldenummer: 92908810.2
(22) Anmeldetag: 24.04.1992
(51) Int. Cl.: G01R 31/00, G01R 35/02, G01D 18/00

(54) **PRÜFSCHALTUNG FÜR EINEN SENSOR**
TEST CIRCUIT FOR A SENSOR
CIRCUIT DE CONTROLE POUR UN CAPTEUR

(30) Priorität: 07.06.1991 DE 4118718
(43) Veröffentlichungstag der Anmeldung: 26.05.1993
(73) Patentinhaber: ROBERT BOSCH GMBH, 70442 Stuttgart (DE)
(72) Erfinder: HEMMINGER, Hermann, D-7145 Markgröningen (DE); JOHNE, Stephan, D-7140 Ludwigsburg (DE)
(86) Internationale Anmeldenummer: DE9200327
(87) Internationale Veröffentlichungsnummer: WO9221985

(56) Entgegenhaltungen:
- WO-A-89/10542
- DE-A- 3 408 960
- GB-A- 1 577 048
- GB-A- 1 588 667

## Beschreibung

Die Erfindung betrifft eine Schaltung zum Prüfen des Funktionszustandes oder Status eines Sensors. Der Sensor kann entweder funktionsfähig sein, oder er kann ein fehlerhaftes Signal ausgeben, was insbesondere durch einen Schluß gegen Masse, einen Schluß gegen die Versorgungsspannung oder durch eine Unterbrechung bedingt ist.

Im folgenden wird in Zusammenhang mit Transistoren u.a. der Begriff "Elektronen empfangende Elektrode" verwendet. Bei Transistoren mit N-Leitung ist dies die Drain bzw. der Kollektor, bei solchen mit P-Leitung die Source bzw. der Emitter.

### Stand der Technik

Besonders wichtig ist eine selbsttätige Statuserkennung für solche Sensoren, die nur in größeren Zeitabständen beobachtet und kontrolliert werden können oder die ihre Signale vollautomatisch arbeitenden Einrichtungen zuführen. In solchen Fällen ist es üblich, Betriebsparameter laufend zu kontrollieren und binäre Statussignale auszugeben.

Beim Überprüfen der Funktionsfähigkeit eines Sensors ist es erwünscht, unterschiedliche Funktionszustände auf möglichst einfache Art erkennen zu können. Es bestand demgemäß das Problem, eine Prüfschaltung für einen Sensor anzugeben, die unterschiedliche Funktionszustände auf einfache Art unterscheidbar macht.

Aus der Druckschrift GB-A-1 577 048, von der ausgehend der Oberbegriff des vorliegenden Anspruchs 1 gebildet worden ist, ist ein Verfahren und eine Vorrichtung zum Ein- und/oder Ausschalten einer mit einem Sensor arbeitenden Regelung bekannt, die eine Prüfschaltung für den Sensor aufweist. Diese Prüfschaltung soll sicherstellen, daß eine Fehlfunktion erkannt wird. Sie umfaßt wenigstens drei Prüftransistoren, wobei der Steuerkreis eines Prüftransistors mit dem Ausgang eines PNP-Prüftransistors verbunden ist. Über die Erkennung der Schaltzustände der Transistoren und aus der Kombination der Schaltzustände der drei Prüftransistoren läßt sich erkennen, ob der Sensor ordnungsgemäß funktioniert.

Aus der Druckschrift GB-A-1 588 667 ist eine Einrichtung zur Verwertung des Ausgangssignales einer Meßsonde mit einem ionenleitenden Festelektrolyten bekannt, bei der das Ausgangssignal der Meßsonde überwacht wird. Die dazu vorgesehene Prüfschaltung weist eine Offset-Spannungsquelle auf, die mit einer Sensorzuleitung verbunden ist und an diese eine Offsetspannung gegenüber Masse abgibt. Verhält sich die Sensorausgangsspannung nicht in der erwarteten Weise, wird auf einen Fehler erkannt.

### Darstellung der Erfindung

Die erfindungsgemäße Prüfschaltung für einen Sensor geht aus von einer Prüfschaltung mit einem ersten (TR1), zweiten (TR2) und dritten (TR3) Prüftransistor, wobei der Steuerkreis des dritten Prüftransistors mit dem Ausgang eines weiteren, mit P-Leitung arbeitenden Transistors (TR4) verbunden ist und der Schaltzustand der drei Prüftransistoren erfaßbar ist und die Kombination der Schaltzustände der drei Prüftransistoren erkennen läßt, ob der Sensor funktionsfähig ist. Die Prüfschaltung ist dadurch gekennzeichnet, daß sie eine Offset-Spannungsquelle (U-OS) umfaßt, die mit der Niederpotentialleitung (LPL) des Sensors (11) verbunden ist, deren Potential tiefer ist als das der Hochpotentialleitung (HPL) des Sensors (11) und die an die Niederpotentialleitung (LPL) eine Offsetspannung gegenüber Masse abgibt, die höher ist als die Transistor-Mindeststeuerspannung, die an der Steuerelektrode des weiteren Transistors (TR4), dessen Schaltstrecke, in Serie mit einer Widerstandsanordnung, zwischen der Versorgungsspannung (VCC) und Masse liegt, erforderlich ist, um ihn durchzusteuern, daß ein Pull-Down-Widerstand (PD) zwischen der Hochpotentialleitung (HPL) und Masse liegt, daß der erste Prüftransistor (TR1), dessen Steuerelektrode über eine Widerstandsanordnung mit der Hochpotentialleitung (HPL) verbunden ist, sperrt, wenn das Potential auf der Hochpotentialleitung (HPL) unter die Transistor-Mindeststeuerspannung fällt, was entweder bei einem Masseschluß des Sensors oder, wegen des Pull-Down-Widerstandes, bei einer Unterbrechung der Hochpotentialleitung (HPL) der Fall ist, daß der zweite Prüftransistor (TR2), dessen Steuerelektrode über eine Widerstandsanordnung mit der Niederpotentialleitung (LPL) verbunden ist, sperrt, wenn die Niederpotentialleitung (LPL) auf Masse liegt, was bei einem Masseschluß der Fall ist, daß die Steuerelektrode des dritten Prüftransistors (TR3) mit dem Ausgang des weiteren Transistors (TR4) verbunden ist, wobei die Steuerelektrode des weiteren Transistors (TR4) mit der Hochpotentialleitung (HPL) des Sensors (11) verbunden ist und so geschaltet ist, daß der weitere Transistor (TR4) sperrt, wenn die Hochpotentialleitung (HPL) ein Potential einnimmt, das mindestens dem Potential der Elektronen empfangenden Elektrode zuzüglich der Mindeststeuerspannung des weiteren Transistors (TR4) entspricht, woraufhin auch der dritte Transistor sperrt, und daß die Kombination der Schaltzustände der drei Prüftransistoren erkennen läßt, welcher der vier Zustände: funktionsfähig, Schluß gegen Masse, Schluß gegen die Versorgungsspannung, Unterbrechung, vorliegt.

Aufgrund der genannten Kombinationen von Schaltzuständen der drei Prüftransistoren sind vier Sensor-Funktionszustände mit nur drei Transistorsignalen überprüfbar. Noch einfacher wird die Auswertung, wenn gemäß einer besonders bevorzugten Ausführungsform zwei der drei Prüftransistoren in Reihe geschaltet sind. Selbst in diesem Fall ergibt sich aus den Kombinationen der Schaltzustände der Transistorreihenschaltung und des restlichen Prüftransistors der jeweilige Funktionszustand des Sensors in eindeutiger Weise. Wird der Sperrzustand eines Transistors mit "1" und der Durchschaltzustand (Verbindung gegen Masse) mit "0" gekennzeichnet, sind die vier Zustände als 2-Bit-Signale "00", "01", "10" und "11" voneinander unterscheidbar.

### Zeichnung

Fig. 1: Schaltbild einer bevorzugten Ausführungsform einer Prüfschaltung für einen Sensor, die mit Hilfe von zwei Prüfsignalen, die jeweils einen von zwei Zuständen einnehmen, insgesamt vier Funktionszustände des Sensors unterscheidet;
Fig. 2: Tabelle, die die Verknüpfung zwischen den Zuständen der beiden Prüfsignale und den Funktionszuständen des Sensors zeigt.

### Beschreibung von Ausführungsbeispielen

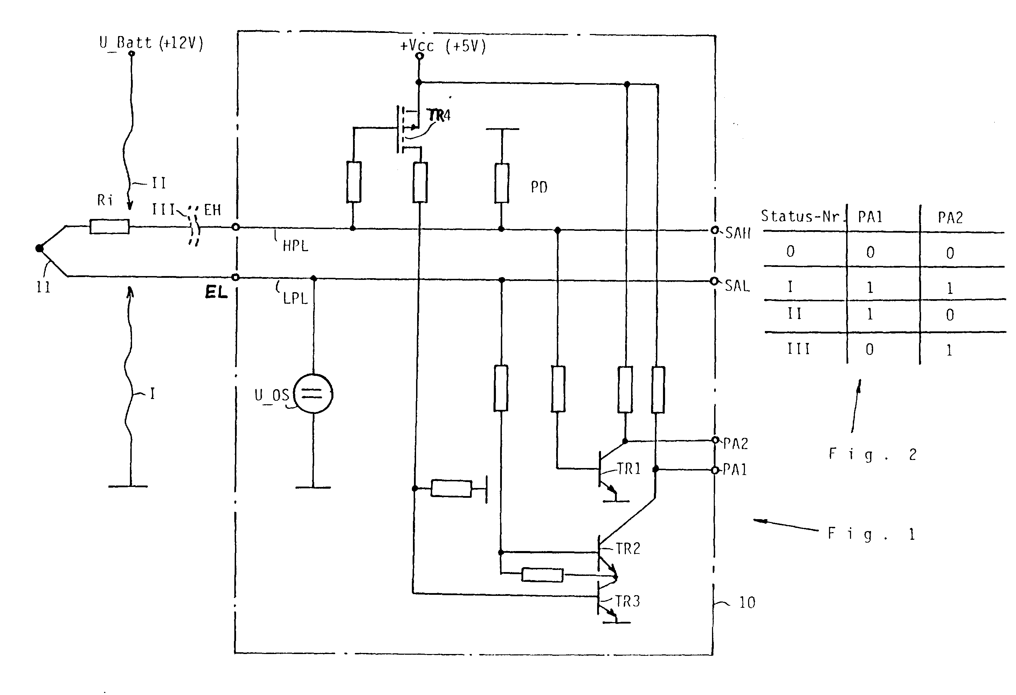

Fig. 1 zeigt eine Prüfschaltung 10, an die ein Thermoelement 11 als Sensor über zwei Eingänge EL und EH angeschlossen ist. Mit dem Eingang EL ist dabei diejenige Leitung des Thermoelements 11 verbunden, deren Potential tiefer ist (Niederpotentialleitung LPL) als das der anderen Leitung (Hochpotentialleitung HPL). Die Hochpotentialleitung ist an den anderen Eingang EH angeschlossen. Die Signale von diesen Eingängen werden über die Hochpotentialleitung HPL bzw. die Niederpotentialleitung LPL unmittelbar an Signalausgänge SAH bzw. SAL geliefert, wo sie zur weiteren Verarbeitung zur Verfügung stehen. Andererseits werden die Signale auf den beiden Leitungen innerhalb der Prüfschaltung 10 ausgewertet, und die Auswertungssignale werden an zwei Prüfausgängen PA1 und PA2 ausgegeben.

Am Thermoelement 11 können insbesondere folgende drei Fehler auftreten: Ein Schluß gegen Masse, was in Fig. 1 mit I gekennzeichnet ist, ein Schluß gegen die Versorgungsspannung, was mit II gekennzeichnet ist, und schließlich eine Leitunqsunterbrechung, was mit III gekennzeichnet ist. Die Schlüsse und Leitungsunterbrechungen können nur auf einer der beiden Sensorleitungen auftreten oder auf beiden.

Für das Folgende wird angenommen, daß als Spannung einer Spannungsquelle eine Batteriespannung U_Batt von + 12 V vorliegt und daß von Transistoren in der Prüfschaltung 10 eine Versorgungsspannung + Vcc von + 5 V genutzt wird.

Wesentlich für die Funktion der Prüfschaltung 10 ist, daß sie eine Offset-Spannungsquelle U_OS aufweist, die das Potential der Niederpotentialleitung LPL gegenüber Masse anhebt, und zwar um eine Offsetspannung, die höher ist als die Transistor-Nindeststeuerspannung. Beim Ausführungsbeispiel gemäß Fig. 1 werden NPN-Si-Transistoren mit einem Basis-Emitter-Spannungsabfall von ca. 0,7 V verwendet. Die Offsetspannung beim Ausführungsbeispiel wurde daher zu 1 V gewählt.

Zwischen der Hochpotentialleitung und Masse liegt ein Pull-Down-Widerstand PD. Da über diesen dauernd ein Strom fließt, der am Innenwiderstand Ri des Thermoelements 11 zu einem Spannungsabfall führt, ist dieser Widerstand so hochohmig gewählt, daß er das Sensorsignal weniger verfälscht, als es der Meßgenauigkeit entspricht. Alternativ könnte die am Innenwiderstand des Sensors abfallende Spannung beim Auswerten des Sensorsignals berücksichtigt werden. Dies ist iedoch nur dann praktikabel, wenn ein Anwendungsfall vorliegt, bei dem die Widerstandswerte sowohl des Innenwiderstandes des Sensors wie auch des Pull-Down-Widerstandes zeitlich im wesentlichen konstant sind.

Solange der Sensor ordnungsgemäß arbeitet, entspricht das Potential auf der Niederpotentialleitung LPL dem Offsetpotential und das Potential auf der Hochpotentialleitung liegt um die Sensorspannung höher. Im Fall einer Unterbrechung wird das Potential auf der Hochpotentialleitung dagegen durch den Pull-Down-Widerstand PD auf Massepotential gezogen. Ebenfalls Massepotential auf der Hochpotentialleitung liegt im Fall eines Masseschlusses dieser Leitung vor. Im Fall eines Masseschlusses der Niederpotentialleitung LPL liegt diese auf Massepotential, und das Potential auf der Hochpotentialleitung HPL ist um die Sensorspannung höher. Kommt die Masseleitung dagegen mit dem hohen Potential der Spannungsquelle (Batterie) oder auch nur mit dem der Versorgungsspannung in Berührung, nimmt sie das entsprechende Potential ein. Das Potential auf der Hochpotentialleitung ist dabei um die Sensorspannung höher. Kommt dagegen die Hochpotentialleitung mit einem der beiden genannten höheren Potentiale in Berührung, nimmt sie das jeweilige höhere Potential ein, während das Potential der Niederpotentialleitung LPL um die Sensorspannung niedriger liegt. Die Potentialunterschiede auf den beiden Leitungen im Fall von Schlüssen gegen Masse oder die genannten höheren Potentiale sind dann unbeachtlich, wenn die maximale Sensorspannung geringer ist als die Durchsteuerspannung des Transistors. Dies ist beim Ausführungsbeispiel vorausgesetzt.

Ein vom Potential der Hochpotentialleitung HPL gesteuerter Transistor ist in Fig. 1 als TR1 bezeichnet. Seine Basis ist mit der Hochpotentialleitung über eine Widerstandsanordnung verbunden. die als einzelner Widerstand dargestellt ist. Sein Kollektor steht über einen Widerstand mit der Betriebsspannung Vcc und sein Emitter mit Masse in Verbindung. Am Kollektor wird das einem zweiten Prüfausgang PA2 zugeführte Signal abgegriffen. Es entspricht dem Massepotential (Zustand "0"), solange der Transistor leitet, was der Fall ist, wenn das Potential auf der Hochpotentialleitung mindestens auf dem Potential der Offset-Spannungsquelle U_OS liegt. Fällt das Potential dagegen wegen einer Unterbrechung oder eines Masseschlusses unter diesen Wert. sperrt der Transistor, und das genannte Signal weist das Potential der Betriebsspannung auf (Zustand "1").

Entsprechend wie der Transistor TR1 das Vorliegen eines Potentials über oder unter dem Offsetpotential auf der Hochpotentialleitung untersucht, untersucht ein Transistor TR2 diese Verhältnisse für die Niederpotentialleitung LPL. Auch dieser Transistor ist ein NPN-Si-Transistor; seine Basis ist über eine Widerstandsordnung mit der Niederpotentialleitung verbunden. Sein Kollektor ist über einen Widerstand an die Betriebsspannung Vcc angeschlossen: das Signal am Kollektor wird einem ersten Prüfausgang PA1 zugeführt. Der Emitter ist allerdings nicht unmittelbar geerdet wie der des Transistors TR1, sondern zwischen ihm und Masse liegt die Schaltstrecke eines Transistors TR3. Daher tritt am ersten Prüfausgang PA1 nicht bereits dann das Signal "0" auf, wenn der Transistor TR2 durchschaltet, sondern dies ist erst dann der Fall, wenn auch der Transistor TR3 geöffnet ist. Wenn einer dieser beiden Transistoren sperrt, hat das Signal am Prüfausgang PA1 den Zustand "1".

Die Basis des eben genannten Transistors TR3 wird durch einen Transistor TR4 gesteuert. Es handelt sich um einen P-Kanal-MOSFET, dessen Source an der Versorgungsspannung von + 5 Volt liegt, dessen Gate über einen Widerstand mit der Hochpotentialleitung HPL verbunden ist und dessen Drain den Transistor TR3 ansteuert. Dieser P-Kanal-MOSFET ist durchgeschaltet, solange das Potential auf seinem Gate, also das Potential der Hochpotentialleitung, niedriger ist als das Sourcepotential, also die Versorgungsspannung. Dann ist auch der Transistor TR3 durchgeschaltet. Dies ändert sich jedoch, sowie das Potential auf der Hochpotentialleitung mindestens auf das der Versorgungsspannung Vcc von + 5 V steigt, was z.B. im Fall eines Schlusses gegen die Spannung von + 12 V der Spannungsquelle (Batterie) der Fall ist. Damit der Transistor TR4 im genannten Fall ordnungsgemäß schaltet, muß die Versorgungsspannung Vcc größer sein als die Summe von Ausgangsspannung des Sensors + Offsetspannung + Mindeststeuerspannung des Transistors TR4.

Fig. 2 veranschaulicht die Zustände der Signale an den Prüfausgängen PA1 und PA2 für die vorstehend beschriebenen Funktionsfälle. Es ist ersichtlich, daß die vier verschiedenen Fälle mit Hilfe der zwei binären Prüfsignale eindeutig voneinander unterscheidbar sind.

Im Ausführungsbeispiel von Fig. 1 ist der Transistor, der die Basis des Transistors TR3 ansteuert, ein Feldeffekttransistor. Dies hat den Vorteil, daß er keinen Steuerstrom benötigt, der über den Pull-Down-Widerstand PD fließen müßte. Dadurch kann der Pull-Down-Widerstand sehr hochohmig gewählt werden, was aus den oben genannten Gründen für die Meßgenauigkeit des Sensorsignals von Vorteil ist. Soll die Prüfschaltung allerdings zusammen mit anderen Schaltungsteilen integriert werden, ist es von Vorteil, wenn alle Schaltelemente mit im wesentlichen gleichen Verfahrensschritten hergestellt werden können, also alle entweder bipolare Transistoren oder Feldeffekttransistoren sind. Je nach Anwendungsfall wird man demgemäß den Transistor TR4 als Feldeffekttransistor oder als bipolaren PNP-Transistor ausbilden, wobei die Verwendung von Feldeffekttransistoren wegen erheblich verringerten Leckströmen und der stromfreien Ansteuerung gegenüber bipolaren Transistoren vorteilhafter ist. Es wird dabei die Schaltung von Fig. 1 entsprechend verwendet, wobei jedoch bei den Transistoren TR1 bis TR3 jeweils die Source des jeweiligen FET's dem Emitter, das Gate der Basis und die Drain dem Kollektor des jeweiligen bipolaren Transistors entspricht. Die Offsetspannung muß dabei entsprechend der höheren Durchsteuerspannung von FETs höher liegen, nämlich bei z.B. 2,5 V statt 1 V.

## Patentansprüche

1. Prüfschaltung für einen Sensor, die einen ersten (TR1), zweiten (TR2) und dritten (TR3) Prüftransistor umfaßt, wobei der Steuerkreis des dritten Prüftransistors (TR3) mit dem Ausgang eines weiteren, mit P-Leitung arbeitenden Transistors (TR4) verbunden ist und der Schaltzustand der drei Prüftransistoren erfaßbar ist und die Kombination der Schaltzustände der drei Prüftransistoren erkennen läßt, ob der Sensor funktionsfähig ist, dadurch gekennzeichnet, daß die Prüfschaltung eine OffsetSpannungsquelle (U-OS) umfaßt, die mit der Niederpotentialleitung (LPL) des Sensors (11) verbunden ist, deren Potential tiefer ist als das der Hochpotentialleitung (HPL) des Sensors (11) und die an die Niederpotentialleitung (LPL) eine Offsetspannung gegenüber Masse abgibt, die höher ist als die Transistor-Mindeststeuerspannung, die an der Steuerelektrode des weiteren Transistors (TR4), dessen Schaltstrecke, in Serie mit einer Widerstandsanordnung, zwischen der Versorgungsspannung (VCC) und Masse liegt, erforderlich ist, um ihn durchzusteuern, daß ein Pull-Down-Widerstand (PD) zwischen der Hochpotentialleitung (HPL) und Masse liegt, daß der erste Prüftransistor (TR1), dessen Steuerelektrode über eine Widerstandsanordnung mit der Hochpotentialleitung (HPL) verbunden ist, sperrt, wenn das Potential auf der Hochpotentialleitung (HPL) unter die Transistor-Mindeststeuerspannung fällt, was entweder bei einem Masseschluß des Sensors oder, wegen des Pull-Down-Widerstandes, bei einer Unterbrechung der Hochpotentialleitung (HPL) der Fall ist, daß der zweite Prüftransistor (TR2), dessen Steuerelektrode über eine Widerstandsanordnung mit der Niederpotentialleitung (LPL) verbunden ist, sperrt, wenn die Niederpotentialleitung (LPL) auf Masse liegt, was bei einem Masseschluß der Fall ist, daß die Steuerelektrode des dritten Prüftransistors (TR3) mit dem Ausgang des weiteren Transistors (TR4) verbunden ist, wobei die Steuerelektrode des weiteren Transistors (TR4) mit der Hochpotentialleitung (HPL) des Sensors (11) verbunden ist und so geschaltet ist, daß der weitere Transistor (TR4) sperrt, wenn die Hochpotentialleitung (HPL) ein Potential einnimmt, das mindestens dem Potential der Elektronen empfangenden Elektrode zuzüglich der Mindeststeuerspannung des weiteren Transistors (TR4) entspricht, woraufhin auch der dritte Transistor sperrt, und daß die Kombination der Schaltzustände der drei Prüftransistoren erkennen läßt, welcher der vier Zustände: funktionsfähig, Schluß gegen Masse, Schluß gegen die Versorgungsspannung, Unterbrechung, vorliegt.

2. Prüfschaltung nach Anspruch 1, dadurch gekennzeichnet, daß die Schaltstrecken zweier Prüftransistoren (TR2, TR3) der drei Prüftransistoren (TR1, TR2, TR3) in Reihe geschaltet sind und demgemäß die Kombination der Schaltzustände der Transistorreihenschaltung und des restlichen Prüftransistors (TR1) den Funktionszustand des Sensors (11) angibt.

3. Prüfschaltung nach einem der Ansprüche 1 oder 2, dadurch gekennzeichnet, daß der Transistor (TR4) ein P-Kanal-FET oder ein bipolarer PNP-Transistor ist.

4. Prüfschaltung nach einem der Ansprüche 1 bis 3, dadurch gekennzeichnet, daß der Pull-Down-Widerstand (PD) hochohmig ist.

## Claims

1. Test circuit for a sensor, which comprises a first (TR1), second (TR2) and third (TR3) test transistor, the control circuit of the third test transistor (TR3) being connected to the output of a further transistor (TR4), which operates with P conduction, and it being possible to sense the switching state of the three test transistors, and the combination of the switching states of the three test transistors making it possible to detect whether the sensor is operative, characterized in that the test circuit comprises an offset voltage source (U-OS), which is connected to the low-potential line (LPL) of the sensor (11) and whose potential is lower than that of the high-potential line (HPL) of the sensor (11) and which outputs to the low-potential line (LPL) an offset voltage with respect to earth which is higher than the transistor minimum control voltage which is necessary at the control electrode of the further transistor (TR4) whose contact break distance is located in series with a resistor arrangement between the supply voltage (VCC) and earth, in order to turn it on, in that a pull-down resistor (PD) is located between the high-potential line (HPL) and earth, in that the first test resistor (TR1), whose control electrode is connected to the high-potential line (HPL) via a resistor arrangement, switches off if the potential on the high-potential line (HPL) drops below the transistor minimum-control voltage, which is the case either in the event of the sensor short-circuiting to earth or, because of the pull-down resistor, is the case in the event of the high-potential line (HPL) being interrupted, in that the second test resistor (TR2), whose control electrode is connected to the low-potential line (LPL) via a resistor arrangement, is switched off if the low-potential line (LPL) is connected to earth, which is the case in the event of a short-circuit to earth, in that the control electrode of the third test transistor (TR3) is connected to the output of the further transistor (TR4), the control electrode of the further transistor (TR4) being connected to the high-potential line (HPL) of the sensor (11) and being switched in such a way that the further transistor (TR4) switches off if the high-potential line (HPL) assumes a potential which corresponds at least to the potential of the electrode receiving electrons plus the minimum control voltage of the further transistor (TR4), in response to which the third transistor also switches off, and in that the combination of the switching states of the three test transistors makes it possible to detect which of the four states: operative, short-circuit to earth, short-circuit to the supply voltage, interruption, is present.

2. Test circuit according to Claim 1, characterized in that the contact break distances of two test transistors (TR2, TR3) of the three test transistors (TR1, TR2, TR3) are connected in series and, accordingly, the combination of the switching states of the transistor series-circuit and of the remaining test transistor (TR1) gives the functional state of the sensor (11).

3. Test circuit according to one of Claims 1 or 2, characterized in that the transistor (TR4) is a P-channel FET or a bipolar PNP transistor.

4. Test circuit according to one of Claims 1 to 3, characterized in that the pull-down resistor (PD) has high impedance.

## Revendications

1. Circuit de contrôle d'un capteur comprenant un premier (TR1), un second (TR2) et un troisième (TR3) transistor de contrôle, le circuit de commande du troisième transistor de contrôle (TR3) étant relié à la sortie d'un autre transistor (TR4) à conduction de type (P), et l'on détecte l'état de commutation des trois transistors de contrôle, la combinaison des états de commutation des trois transistors de contrôle permettant de savoir si le capteur est apte à fonctionner,
caractérisé en ce que
- le circuit de contrôle comprend une source de tension de décalage (U-OS) reliée à la ligne de potentiel bas (LPL) du capteur (11) dont le potentiel est inférieur à la ligne de potentiel haut (HPL) du capteur (11), et qui fournit une tension de décalage par rapport à la masse pour la ligne de potentiel bas (LPL), décalage supérieur à la tension de commande de transistor minimale nécessaire à l'électrode de commande de l'autre transistor (TR4) pour le débloquer, et dont le chemin de commutation est en série avec un dispositif à résistance entre la tension d'alimentation (Vcc) et la masse.
- une résistance d'abaissement (PD) est prévue entre la ligne de potentiel haut (HPL) et la masse,
- le premier transistor de contrôle (TR1) dont l'électrode de commande est reliée, par le dispositif à résistance, avec la ligne de potentiel haut (HPL), se bloque si le potentiel appliqué à la ligne de potentiel haut (HPL) descend en dessous de la tension de commande minimale de transistor, ce qui est le cas soit lors d'un court-circuit à la masse pour le capteur, soit à cause de la résistance d'abaissement lors d'une coupure de la ligne de potentiel haut (HPL), et le second transistor de contrôle (TR2) dont l'électrode de commande est reliée, par un dispositif à résistance, avec la ligne de potentiel bas (LPL), se bloque lorsque la ligne de potentiel bas (LPL) est à la masse, ce qui est le cas pour un court-circuit à la masse,
- l'électrode de commande du troisième transistor de contrôle (TR3) est reliée à la sortie de l'autre transistor (TR4),
- l'électrode de commande de cet autre transistor (TR4), reliée à la ligne de potentiel haut (HPL) du capteur (11), est branchée pour que cet autre transistor (TR4) se bloque si la ligne de potentiel haut (HPL) prend un potentiel correspondant au moins au potentiel de l'électrode recevant les électrons, augmenté de la tension de commande minimale de l'autre transistor (TR4),
- puis le troisième transistor se bloque et permet de reconnaître la combinaison des états de commutation des trois transistors de contrôle, pour déterminer l'état appliqué, à savoir : aptitude à fonctionner, court-circuit avec la masse, court-circuit avec la tension d'alimentation, coupure.

2. Circuit de contrôle selon la revendication 1,
caractérisé en ce que
les chemins de commutation de deux transistors de contrôle (TR2, TR3) parmi les trois transistors de contrôle (TR1, TR2, TR3) sont branchés en série, de sorte que la combinaison des états de commutation du montage en série des transistors et du transistor de contrôle résiduel (TR1) indique l'état de fonctionnement du capteur (11).

3. Circuit de contrôle selon l'une des revendications 1 ou 2,
caractérisé en ce que
le transistor (TR4) est un transistor FET à canal P ou un transistor PNP bipolaire.

4. Circuit de contrôle selon l'une des revendications 1 à 3,
caractérisé en ce que
la résistance d'abaissement (PD) est fortement ohmique.
